# EUROPÄISCHE PATENTANMELDUNG

(11) **EP 1 612 568 A1**
(43) Veröffentlichungstag der Anmeldung: **04.01.2006**
(21) Anmeldenummer: 05105777.6
(22) Anmeldetag: 29.06.2005
(51) Int. Cl.: G01R 27/00, G01R 27/26, G01N 27/22

(54) **Vorrichtung zum Erfassen der Resonanzfrequenz und Güte eines Schwingkreises in einem Sensor**

(30) Priorität: 02.07.2004 DE 102004032031
(71) Anmelder: Hella KGaA Hueck & Co., 59552 Lippstadt (DE)
(72) Erfinder: Schmidt, Franz-Josef, 33154, Salzkotten (DE)

(57) **Zusammenfassung**

Vorrichtung zum Erfassen der Resonanzfrequenz und/oder Güte eines Schwingkreises (6) eines Sensors mit folgenden Merkmalen:
- die Vorrichtung weist Mittel (1) zum Erzeugen einer vorzugsweise sinusförmigen Schwingung (Erregerschwingung) auf;
- die Vorrichtung weist Mittel (3) zum Einkoppeln der Erregerschwingungen in den Schwingkreis (6) auf;
- die Vorrichtung weist Mittel (4) zum Auskoppeln von Schwingungen aus dem Schwingkreis (Schwingkreisschwingungen) auf;
- die Vorrichtung weist Mittel (5) zum Erzeugen von Referenzschwingungen auf;
- die Vorrichtung weist ein Mittel (1) zum Vergleichen einer Phasenlage von ausgekoppelten Schwingkreisschwingungen (Empfängerschwingungen) mit einer Phasenlage der Referenzschwingungen auf.

## Beschreibung

### STAND DER TECHNIK

Die Erfindung betrifft eine Vorrichtung zum Erfassen der Resonanzfrequenz und/oder der Güte des Schwingkreises in einem Sensor.

Aus der Patentschrift mit der Veröffentlichungsnummer DE 101 27 990 C2 und der Patentschrift zu dem Patent mit der Nummer US 4,703,237 sind Vorrichtungen zum Erfassen der Resonanzfrequenz eines Schwingkreises bekannt. Eine solche Vorrichtung mit einem solchen Schwingkreis wird gemäß der Druckschriften dazu verwendet, die Feuchtigkeit, insbesondere auf der Windschutzscheibe eines Kraftfahrzeugs zu erfassen. Durch den Einfluss der Feuchtigkeit ändert sich die Kapazität in dem Schwingkreis. Diese Kapazitätsänderung führt zu einer Verstimmung, d. h. zu einer Änderung der Resonanzfrequenz.

Durch ein Anregen des Schwingkreises mit Erregerschwingungen verschiedener Frequenzen, kann die Resonanzfrequenz des Schwingkreises festgestellt werden. Aus der festgestellten Resonanzfrequenz kann dann die Kapazität beziehungsweise der damit verbundene Feuchtegrad bestimmt werden. Bei den in den Druckschriften beschriebenen Vorrichtungen ist es, wie die Praxis gezeigt hat, schwierig die Resonanzfrequenz des Schwingkreises möglichst unverfälscht und mit hoher Auflösung und Genauigkeit zu erfassen. Die in den Druckschriften vorgestellten Lösungen sind diesbezüglich nicht vollständig zufriedenstellend. Das Problem der Vorrichtungen liegt darin, dass durch das Einkoppeln der Erregerschwingungen in den Schwingkreis, die Resonanzfrequenz und die Amplitude der Schwingung verfälscht wird. Die gesamte Anordnung hat nämlich eine unerwünschte Rückwirkung auf das Messergebnis.

Hier setzt die vorliegende Erfindung an.

Der Erfindung liegt die Aufgabe zugrunde, eine Vorrichtung zum Erfassen der Resonanzfrequenz und/oder der Güte eines Schwingkreises in einem Sensor zu finden, wobei die Größen mit größerer Genauigkeit, Auflösung und geringeren Rückwirkungen ermittelt werden sollen.

Eine weitere Anforderung an die Vorrichtung ist, dass sie grundsätzlich zur Messung von Feuchtigkeit oder anderen Größen geeignet sein soll.

### VORTEILE DER ERFINDUNG

Die Aufgabe wird erfindungsgemäß durch eine Vorrichtung nach Anspruch 1 gelöst. Eine erfindungsgemäße Vorrichtung weist demnach ein Mittel zum Erzeugen einer vorzugsweise sinusförmigen Schwingung, der sogenannten Erregerschwingung auf. Diese Erregerschwingung wird mittels eines Mittels zum Einkoppeln in den Schwingkreis eingekoppelt, beziehungsweise kann mittels der Mittel in den Schwingkreis eingekoppelt werden. Die erfindungsgemäße Vorrichtung weist ferner ein Mittel zum Auskoppeln von Schwingungen aus dem Schwingkreis, die sogenannten Schwingkreisschwingungen, auf. Ferner umfasst die Vorrichtung ein Mittel zum Erzeugen von Referenzschwingungen, die dann mit dem mittels des Mittels zum Auskoppeln ausgekoppelten Schwingkreisschwingungen verglichen werden. Die ausgekoppelten Schwingkreisschwingungen werden Empfängerschwingungen genannt. Die Empfängerschwingungen und die Referenzschwingungen werden derart verglichen, dass die Phasenlage der Schwingkreisschwingungen mit der Phasenlage der Referenzschwingungen verglichen wird. Es wird also der Phasenwinkel zwischen Strom und Spannung der Empfängerschwingungen mit dem Phasenwinkel zwischen Strom und Spannung der Referenzschwingungen verglichen. Ebenso wäre es möglich, die Phasenwinkel zwischen Spannung und Strom zu vergleichen. Das Mittel zum Erzeugen der Erregerschwingungen kann zugleich das Mittel zum Erzeugen der Referenzschwingungen sein.

Vorteilhaft wird bei einer erfindungsgemäßen Vorrichtung die Differenz der Phasenwinkel gebildet, die dann mittels eines Mittels zum Regeln geregelt werden kann. Als Stellglied ist dabei insbesondere das Mittel zum Erzeugen der sinusförmigen Erregerschwingungen geeignet, wobei die Stellgröße die Frequenz der Erregerschwingung ist.

Eine erfindungsgemäße Vorrichtung kann ein Mittel zum Erzeugen eines zur Frequenz der Erregerschwingung proportionalen Ausgangssignals aufweisen. Dieses ist vorteilhaft, da die Frequenz der Erregerschwingung im eingeregelten Zustand der Vorrichtung bei einem geeigneten Sollwert für die Phasendifferenz der Eigenfrequenz des Schwingkreises entspricht.

Eine erfindungsgemäße Vorrichtung kann ferner ein Mittel zum Regeln der Amplitude der Empfängerschwingungen haben. Mit dem Mittel zur Regelung der Amplitude kann gewährleistet werden, dass die Amplitude der Empfängerschwingungen nicht über ein insbesondere im Hinblick auf die elektromagnetische Verträglichkeit notwendiges Maß hinausgeht. Ferner ist es möglich, durch äußere Störquellen in den Schwingkreis eingekoppelte Signale zumindest qualitativ zu erfassen und zumindest bei einer weiteren Verarbeitung des Ausgangssignals auszublenden. Ferner ist es möglich, über ein Mittel zum Feststellen des Verhältnisses der Amplitude der Empfängerschwingungen zur Amplitude der Erregerschwingungen eine Aussage über die Güte des Schwingkreises zu treffen.

Das Mittel zum Einkoppeln, das Mittel zum Auskoppeln und/oder das Mittel zum Erzeugen der Referenzschwingungen weisen vorteilhaft eine Spule auf.

Eine erfindungsgemäße Vorrichtung kann einen integrierten Schaltkreis aufweisen, der das Mittel zum Erzeugen der Erregerschwingungen, das Mittel zum Vergleichen der Phasenlagen, das Mittel zum Regeln der Differenz zwischen den Phasenlagen und/oder das Mittel zum Erzeugen des Ausgangssignals umfasst. Der integrierte Schaltkreis kann als ASIC realisiert sein.

Die Spule des Mittels zum Einkoppeln kann mit der Spule des Mittels zum Erzeugen der Referenzschwingungen nach Art eines Transformators gekoppelt sein. Der Vorteil einer derartigen Kopplung ist, dass Strom und Spannung in beiden Spulen in Phase zueinander sind.

Eine erfindungsgemäße Vorrichtung kann ferner den Schwingkreis mit einem ohmschen Widerstand, einer Spule und einer Kapazität umfassen.

Die Spule des Mittels zum Einkoppeln kann mit der Spule des Schwingkreises nach Art eines Resonanztransformators lose gekoppelt sein. Damit müssen Strom und Spannung dieser beiden Spulen nicht phasengleich sein. Ferner ist es möglich, dass die Spule des Schwingkreises nach Art eines Transformators mit der Spule des Mittels zum Auskoppeln gekoppelt ist.

In einer vorteilhaften Ausführung können der Schwingkreis und die übrige Vorrichtung galvanisch voneinander getrennt sein. Damit ist es möglich, den Schwingkreis als integralen Bestandteil einer Windschutzscheibe vorzusehen, während die übrigen Spulen außerhalb des Schwingkreises in unmittelbarer Nähe auf der Scheibe oder in der Scheibe angebracht sein können.

### ZEICHNUNGEN

Ein erfindungsgemäßes Ausführungsbeispiel für eine Vorrichtung zum Erfassen der Resonanzfrequenz eines Schwingkreises ist anhand der Zeichnung näher beschrieben. Darin zeigt
- Fig. 1: ein Schaltbild der erfindungsgemäßen Vorrichtung und
- Fig. 2: die Phasenlage von Referenzschwingungen und die Phasenlage von Empfängerschwingungen.

### BESCHREIBUNG DER AUSFÜHRUNGSBEISPIELE

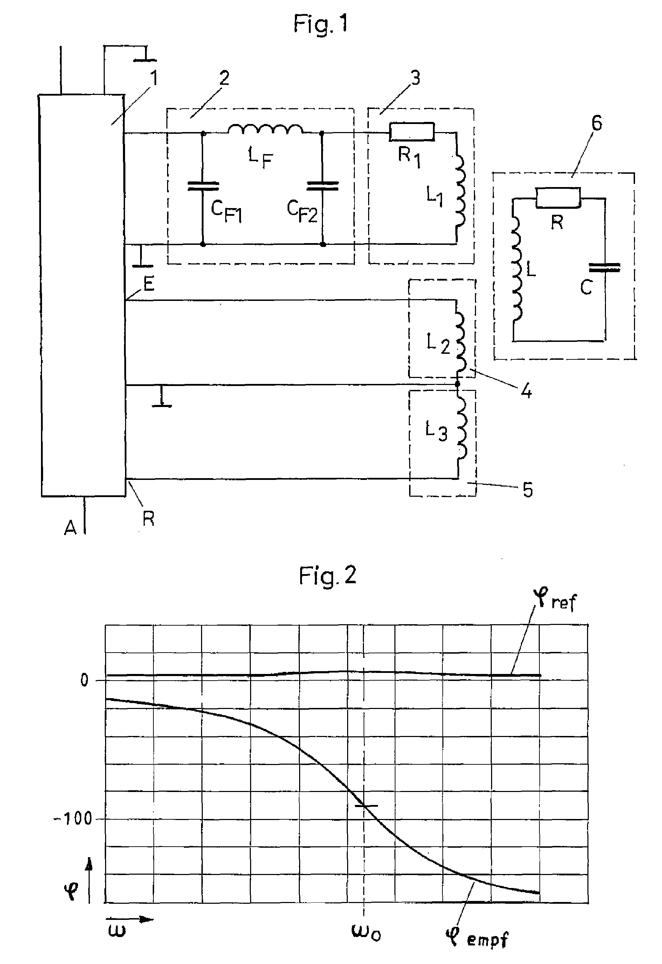

Die in Fig. 1 dargestellte Vorrichtung umfasst einen integrierten Schaltkreis 1, einen Bandpass 2, ein Mittel 3 zum Einkoppeln von Erregerschwingungen in einen Schwingkreis 6, den Schwingkreis 6 selbst, ein Mittel zum Auskoppeln von Schwingungen des Schwingkreises (Schwingkreisschwingungen) und ein Mittel 15 zum Erzeugen von Referenzschwingungen 5.

Der integrierte Schaltkreis 1 umfasst ein Mittel zum Erzeugen einer sinusförmigen Schwingung (Erregerschwingung). Diese Erregerschwingung wird auf dem Bandpass 2 gegeben. Durch den Bandpass werden Oberschwingungen und andere Störungen ausgefiltert. Der Bandpass umfasst dazu zwei Kondensatoren C_{F1}, C_{F2} und eine Spule L_{F}, die in bekannter Art und Weise zueinander angeordnet sind.

Die gefilterten Erregerschwingungen werden vom Bandpass 2 auf das Mittel 3 zum Einkoppeln der Erregerschwingungen in den Schwingkreis 6 gegeben. Das Mittel 3 zum Einkoppeln der Erregerschwingungen umfasst einen Widerstand R₁ und eine Spule L₁. Der Widerstand R₁ steht in der dargestellten Schaltungsanordnung für die Leitungsverluste in den Zuleitungen zur Spule L₁ beziehungsweise für Leitungsverluste in der Spule L₁. Die eigentliche Einkopplung der Erregerschwingungen in den Schwingkreis 6 erfolgt über die Spule L₁. Die Spule L₁ ist dazu nach Art eines Resonanztransformators mit einer Spule L des Schwingkreises 6 lose gekoppelt.

Neben der Spule L umfasst der Schwingkreis einen Widerstand R und einen Kondensator C, wobei der Widerstand R durch die Leitungsverluste einer Leitung des Schwingkreises sowie durch Streuverluste in der Spule L gebildet werden kann. Die Kapazität C kann durch ein Bauelement oder aber durch die parasitären Kapazitäten der Spule beziehungsweise der Leitungen gebildet werden.

Die Spule L des Schwingkreises 6 ist neben der Spule L₁ des Mittels 3 zum Einkoppeln der Erregerschwingungen auch mit einer Spule L₂ des Mittels 4 zum Auskoppeln der in dem Schwingkreis 6 vorliegenden Schwingkreisschwingungen nach Art eines Transformators verbunden. Die Spule L₂, die im Übrigen das vollständige Mittel zum Auskoppeln der Schwingkreisschwingungen bildet und in der dann Empfängerschwingungen vorliegen, ist mit dem integrierten Schaltkreis 1 verbunden.

Mit dem integrierten Schaltkreis 1 ist ferner das Mittel 5 zum Erzeugen der Referenzschwingungen verbunden. Das Mittel 5 zum Erzeugen der Referenzschwingungen ist dazu mit dem Mittel zum Einkoppeln verbunden. Die Erregerschwingungen werden von dem Mittel zum Einkoppeln der Erregerschwingungen über die Spule L₁ in eine Spule L₃ des Mittels zum Erzeugen der Referenzschwingungen eingekoppelt. Das Mittel zum Erzeugen der Referenzschwingungen wird durch die Spule L₃ gebildet. Die Kopplung zwischen der Spule L₃ und der Spule L₁ ist zeichnerisch nicht dargestellt.

Der integrierte Schaltkreis 1 weist ferner ein Mittel zum Vergleichen der Phasenlage der Empfängerschwingungen mit der Phasenlage der Referenzschwingungen auf. Dieses Mittel zum Vergleichen der Phasenlage ist dazu mit den Eingängen E, R des integrierten Schaltkreises verbunden, über welche dem integrierten Schaltkreis die Empfängerschwingungen beziehungsweise die Referenzschwingungen zugeleitet werden. Dazu werden die Spannungen über der Spule L₂ des Mittels 4 zum Auskoppeln und die über der Spule L₃ des Mittels 5 zum Erzeugen des Referenzschwingungen möglichst stromlos erfasst.

Sofern es sich bei den Erregerschwingungen um eine sinusförmige Spannung handelt, wird die Phasenlage der Spannung über dem Mittel 4 zum Auskoppeln der Spannung über der Spule L des Schwingkreises mit der Phasenlage der Spannung über dem Mittel 5 zum Erzeugen der Referenzspannung zum Auskoppeln der Spannung über der Spule L₁ des Mittels 3 zum Erzeugen verglichen. Das Ergebnis dieses Vergleichs, das vorzugsweise als Phasendifferenz vorliegt, wird einem Mittel zum Regeln der Phasendifferenz, d. h. der Differenz zwischen der Phasenlage der Empfängerschwingungen und der Phasenlage der Referenzschwingungen zugeleitet. Das Mittel zum Regeln, das ebenfalls Teil des integrierten Schaltkreises 1 ist, regelt die Phasendifferenz auf einen Sollwert beispielsweise von -90°. Ist der Sollwert erreicht, liegt in dem Schwingkreis 6 eine Schwingung mit der Resonanzfrequenz vor, was anhand von Fig. 2 noch näher erläutert wird.

In dem integrierten Schaltkreis kann ferner ein Mittel zum Erzeugen eines Ausgangssignals vorgesehen sein, wobei das erzeugte Ausgangssignal proportional zur Frequenz der Erregerspannung ist. Sofern mittels des Mittels zum Regeln der Phasendifferenz die Erregerschwingung auf eine Frequenz eingestellt ist, so dass der Sollwert Phasendifferenz erreicht ist und somit die Schwingkreisschwingung mit der Eigenfrequenz des Schwingkreises schwingt, kann über das zur Erregerfrequenz proportionale Ausgangssignal an einem Ausgang A des integrierten Schaltkreises eine Information über die Eigenfrequenz des Schwingkreises 6 abgegriffen werden.

Anhand von Fig. 2 soll nun der Zusammenhang zwischen der Phase der Referenzspannung, der Phase der Empfängerschwingungen und der Eigenfrequenz erläutert werden. In der Fig. 2 ist mit ϕ_{ref} der Phasenverlauf der Referenzschwingungen über verschiedene Frequenzen dargestellt. Die Phase der Referenzschwingungen ist annähernd konstant, fast Null. Dieses erklärt sich durch die transformatorische Kopplung der Spule L₃ mit der Spule L₁. Durch diese transformatorische Kopplung sind sowohl Spannung als auch Strom in den Spulen L₁, L₃ in Phase.

Anders dagegen sieht es mit der Phase der Empfängerschwingungen in der Spule L₂ aus, deren Verlauf in Fig. 2 mit ϕ_{empf} bezeichnet ist. Zwar liegt auch zwischen der Spule L₂ und der Spule L des Schwingkreises 6 eine transformatorische Kopplung vor, durch die Kapazität C im Schwingkreis ergibt sich jedoch eine Phasenverschiebung zwischen Strom und Spannung im Schwingkreis sowie in der Spule L₂ des Mittels zum Auskoppeln der Schwingkreisschwingungen. Je nach Frequenz hat der Schwingkreis eher die Eigenschaften eines Kondensators oder einer Induktivität. Bei niedrigen Frequenzen liegen eher die Eigenschaften einer Induktivität vor, während bei hohen Frequenzen eher die Eigenschaften einer Kapazität vorliegen. Die Eigenfrequenz des Schwingkreises 6 bildet dabei die Grenze zwischen dem eher induktiven Betrieb und dem eher kapazitiven Betrieb des Schwingkreises.

Die Eigenfrequenz ist immer einem festen Wert der Phasenverschiebung zugeordnet. Im vorliegenden Beispiel ist dieser -90°.

Sofern durch eine Änderung der Kapazität des Schwingkreises 6 sich die Eigenfrequenz verschiebt, ändert sich der Verlauf der Phase ϕempf der Empfängerschwingung. Gleichfalls ändert sich die Phasendifferenz ϕref-ϕempf zwischen der Empfängerschwingung und der Referenzschwingungen für vorgegebene Frequenzen, wobei die Phasendifferenz für die Eigenfrequenz konstant ist und sich der Betrag der Eigenfrequenz ändert. Wird nun die Phasendifferenz zwischen der Phase der Empfängerschwingung und der Phase der Referenzschwingung geregelt, und zwar auf den bei der Eigenfrequenz vorliegenden Wert der Phasendifferenz, schwingt der Schwingkreis 6 automatisch mit seiner Eigenfrequenz. Diese Eigenfrequenz entspricht dann der Frequenz der Erregerschwingungen, die an dem Ausgang A des integrierten Schaltkreises 1 abgegriffen werden kann.

## Patentansprüche

1. Vorrichtung zum Erfassen der Resonanzfrequenz und/oder Güte eines Schwingkreises (6) eines Sensors mit folgenden Merkmalen:
- die Vorrichtung weist Mittel (1) zum Erzeugen einer vorzugsweise sinusförmigen Schwingung (Erregerschwingung) auf;
- die Vorrichtung weist Mittel (3) zum Einkoppeln der Erregerschwingungen in den Schwingkreis (6) auf;
- die Vorrichtung weist Mittel (4) zum Auskoppeln von Schwingungen aus dem Schwingkreis
(Schwingkreisschwingungen) auf;
- die Vorrichtung weist Mittel (5) zum Erzeugen von Referenzschwingungen auf;
- die Vorrichtung weist ein Mittel (1) zum Vergleichen einer Phasenlage von ausgekoppelten Schwingkreisschwingungen (Empfängerschwingungen) mit einer Phasenlage der Referenzschwingungen auf.

2. Vorrichtung nach Anspruch 1, **dadurch gekennzeichnet, dass** die Vorrichtung ein Mittel (1) zum Regeln einer Differenz zwischen den Phasenlagen der Empfängerschwingungen und den Phasenlagen der Referenzschwingungen aufweist.

3. Vorrichtung nach Anspruch 1 oder 2, **dadurch gekennzeichnet, dass** die Vorrichtung ein Mittel (1) zum Erzeugen eines zur Frequenz der Erregerschwingung proportionalen Ausgangssignals aufweist.

4. Vorrichtung nach einem der Ansprüche 1 bis 3, **dadurch gekennzeichnet, dass** die Vorrichtung ein Mittel (1) zum Regeln der Amplitude der Empfängerschwingungen hat.

5. Vorrichtung nach einem der Ansprüche 1 bis 4, **dadurch gekennzeichnet, dass** das Mittel (3) zum Einkoppeln, das Mittel (4) zum Auskoppeln und/oder das Mittel (5) zum Erzeugen der Referenzschwingungen eine Spule (L₁, L₂, L₃) umfasst.

6. Vorrichtung nach einem der Ansprüche 1 bis 5, **dadurch gekennzeichnet, dass** die Vorrichtung einen integrierten Schaltkreis (1) aufweist, der das Mittel zum Erzeugen der Erregerschwingungen, das Mittel zum Vergleichen der Phasenlage, das Mittel zum Regeln der Differenz zwischen den Phasenlagen und/oder das Mittel zum Erzeugen des Ausgangssignals umfasst.

7. Vorrichtung nach einem der Ansprüche 1 bis 6, **dadurch gekennzeichnet, dass** die Spule (L₁) des Mittels (3) zum Einkoppeln mit der Spule (L₃) des Mittels (5) zum Erzeugen der Referenzschwingungen nach Art eines Transformators gekoppelt ist.

8. Vorrichtung nach einem der Ansprüche 1 bis 7, **dadurch gekennzeichnet, dass** die Vorrichtung den Schwingkreis (6) mit einem ohmschen Widerstand (R), einer Spule (L) und einer Kapazität (C) umfasst.

9. Vorrichtung nach Anspruch 8, **dadurch gekennzeichnet, dass** die Spule (L₁) des Mittels (3) zum Einkoppeln nach Art eines Resonanztransformators mit der Spule (L) des Schwingkreises (6) und/oder die Spule (L) des Schwingkreises (6) nach Art eines Resonanztransformators mit der Spule (L₂) des Mittels (4) zum Auskoppeln gekoppelt ist.

10. Vorrichtung nach Anspruch 9, **dadurch gekennzeichnet, dass** der Schwingkreis (6) und die übrige Vorrichtung galvanisch voneinander getrennt sind.
